# EUROPEAN PATENT SPECIFICATION

(11) **EP 2 711 138 B1**
(45) Date of publication and mention of the grant of the patent: **07.11.2018**
(21) Application number: 13182725.5
(22) Date of filing: 03.09.2013
(51) Int. Cl.: B25F 5/00

(54) **Power tool**
Kraftgetriebenes Handwerkzeug
Outil électrique

(30) Priority: 13.09.2012 JP 2012201423
(43) Date of publication of application: 26.03.2014
(73) Proprietor: Panasonic Intellectual Property Management Co., Ltd., Osaka-shi, Osaka 540-6207 (JP)
(72) Inventor: Iwamura, Norihiro, Osaka, 540-6207 (JP); Ikeda, Masaki, Osaka, 540-6207 (JP)
(74) Representative: Appelt, Christian W.

(56) References cited:
- EP-A1- 2 424 091
- US-A1- 2003 047 331
- US-A1- 2010 218 966

## Description

The present invention relates to a power tool.

A power tool includes a battery pack formed by a rechargeable battery (refer to, for example, Japanese Laid-Open Patent Publication Nos. 2012-71362, 11-20187, and 2007-992).

In such a power tool, it is desirable that over-discharging be obviated in the battery pack that is formed by a rechargeable battery. Thus, when an output voltage of the battery pack becomes lower than a predetermined value, the power tool stops a motor in order to stop discharging of the battery pack.

However, the battery pack includes internal resistance of the battery cells and resistance between the wires. As the discharge current increases, the internal resistance of the battery cells and resistance between the wires increase the voltage drop. This lowers the virtual battery voltage. Thus, the generation of a flow of current used to start the motor or current used when the motor locks may cause the voltage of the battery pack to be lower than or equal to the predetermined value and stop the motor even though the actual state of charge of the battery is still sufficient.

US 2003/0047331 A1 describes a control system for driving a power tool which comprises a power source, a motor adapted to drive a shaft, a power switching unit interconnecting the power source and the motor, and a controller. The power switching unit applies a pulse width modulated (PWM) drive signal from the power source to the motor. The controller monitors at least one electrical characteristic of at least one of the power source, motor and power switching unit and adjusts the operating duty cycle of the PWM drive signal based on the electrical characteristics.

EP 2 424 091 A1 describes a switching apparatus that includes a DC voltage output unit, a switching element to supply the DC voltage to a load, a power detection unit to detect power supplied from the switching element to the load, a drive unit to control the switching element in PWM manner according to an output from the power detection unit, and a stop unit to stop the PWM control if a value of the DC voltage is lower than a threshold value. The threshold value is lower than a minimum operation voltage value of the power detection unit.

US 2010/0218966 A1 describes a battery-pack operated hand-held power tool. An electric drive motor is arranged in a device housing for operating a working tool. The battery pack provides electric energy for operating the motor. An electronic control unit is connected to the motor and the battery pack. An operating element disposed on a grip controls the motor. An electric actuator is acted upon by the operating element and the output signal of the electric actuator is supplied to the electronic control unit. Electric energy is applied to the electric drive motor by the electronic control unit as a function of a position of the operating element. The electronic control unit supplies direct current from the battery pack in the form of a PWM signal sequence to the drive motor wherein the signal strength has a voltage that is smaller than the voltage of the battery pack.

It is an object of the present invention to provide a power tool that improves operability.

The object is solved by the features of independent claim 1.

One aspect of the present disclosure is a power tool including a motor, a rechargeable battery that supplies power to the motor, a voltage measurement unit that detects a battery voltage of the rechargeable battery, and a switch that is operable by a user. The switch drives the motor when operated by the user. A control unit controls the power supplied to the motor in response to the operation of the switch. Whenever the voltage detected by the voltage measurement unit decreases and becomes lower than or equal to a predetermined value, the control unit drives the motor to generate an output that is smaller than that before the voltage decreased and became lower than or equal to the predetermined value.

The present invention improves the operability.

The invention, together with objects and advantages thereof, may best be understood by reference to the following description of the presently preferred embodiments together with the accompanying drawings in which:
Fig. 1 is a schematic diagram of a power tool according to one embodiment of the present invention;
Fig. 2 is a schematic configuration diagram of a main body in the power tool shown in Fig. 1;
Fig. 3 is a perspective view of a battery pack in the power tool shown in Fig. 1;
Fig. 4 is an electric circuit diagram illustrating the electrical configuration of the power tool shown in Fig. 1;
Fig. 5 is a timing chart illustrating an example of the operation of the power tool shown in Fig. 1;
Fig. 6 is a timing chart illustrating an example of the operation of a modification of the power tool;
Fig. 7 is a graph illustrating the relationship of the internal temperature and the internal resistance of the battery pack; and
Fig. 8 is a graph illustrating the relationship of the pulled amount of a trigger switch and the duty ratio (motor output) under different limited values.

One embodiment of a power tool 10 will now be described with reference to the drawings.

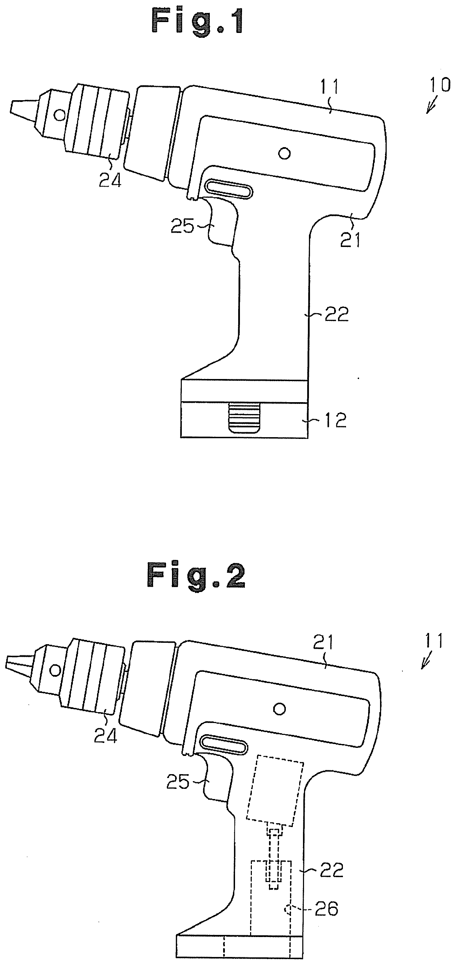

As shown in Figs. 1 to 3, the power tool 10, which is of a rechargeable type, includes a main body 11, which forms, for example, a rechargeable drill driver, and a battery pack 12, which is attached to the main body 11 in a removable manner.

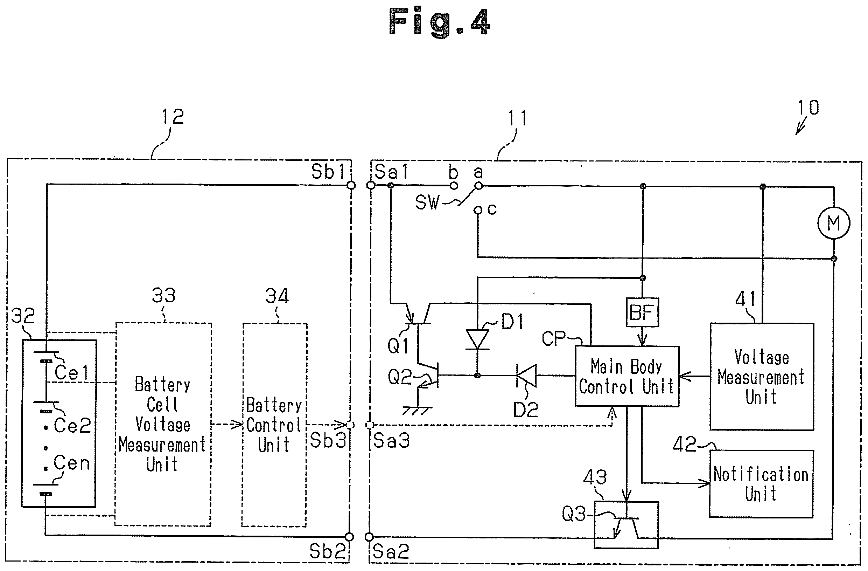

As shown in Fig. 2, the main body 11 includes a substantially tubular housing 21 and a grip 22, which extends downward from the longitudinally middle portion of the housing 21. Referring to Figs. 1 and 4, the main body 11 includes a motor M, a speed reduction mechanism (not shown), and an output unit 24. The motor M is accommodated in the housing 21 and functions as a load. The speed reduction mechanism is coupled to the motor M and includes a train of gears. The output unit 24 is rotatably arranged on a distal end of the housing 21. A tip tool (bit) may be coupled to the tip of the output unit 24. The motor M transmits driving force to the output unit 24 through the speed reduction mechanism.

As shown in Fig. 2, the grip 22 includes a trigger switch 25 used by a user to operate and stop the power tool 10. The user adjusts the amount the trigger switch 25 is pulled to regulate the amount of power supplied to the motor M and thereby controls the rotation speed of the motor M.

As shown in Fig. 1, the grip 22 of the main body 11 has a lower end including a recess, or socket 26 that receives the battery pack 12. Two power receiving electrodes Sa1 and Sa2, which are electrically connected to the battery pack 12, are arranged on a wall of the socket 26. The battery pack 12 includes two power supplying electrode Sb1 and Sb2 that are electrically connected to the two power supplying electrodes Sa1 and Sa2, respectively. When the battery pack 12 is fitted to the socket 26 and arranged at a predetermined position, the two power receiving electrodes Sa1 and Sa2 and the two power supplying electrodes Sb1 and Sb2 of the battery pack 12 are electrically connected when coming into contact with each other.

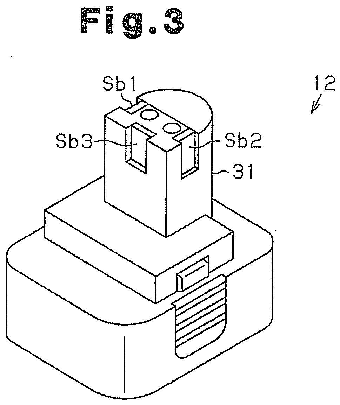

As shown in Fig. 3, the battery pack 12 includes a main body and a head 31 that projects out from the main body. The two power supplying electrodes Sb1 and Sb2 are arranged on a distal end of the head 31. When the head 31 is fitted into the socket 26 of the main body 11, the two power supplying electrodes Sb1 and Sb2 respectively come into contact under pressure with the two power receiving electrodes Sa1 and Sa2 of the socket 26. There is no limitation to how the battery pack 12 is attached to the main body 11. For example, when attaching and removing the battery pack 12 to and from the main body 11, the battery pack 12 may slide in a direction generally orthogonal to the grip 22 at the lower surface of the grip 22.

Referring to Figs. 3 and 4, the battery pack 12 includes a rechargeable battery 32 arranged in the battery pack 12. The rechargeable battery 32 includes a plurality of series-connected battery cells Ce1 to Cen. The battery pack 12 may be a lithium-ion rechargeable battery, a nickel metal-hydride rechargeable battery, a nickel-cadmium rechargeable battery, or the like.

Fig. 4 is a block diagram showing the electrical configuration of the rechargeable power tool in the present embodiment.

The electrical configuration of the battery pack 12 will now be described. In Fig. 3, the rechargeable battery 32 connects the power supplying electrode Sb1 to the power supplying electrode Sb2.

The electrical configuration of the main body 11 will now be described.

As shown in Fig. 4, the power receiving electrode Sa1 is connected to a contact b of a switch SW and the emitter of a PNP-type transistor Q1, which is an example of a switch element including a control terminal. A contact a of the switch SW is connected to one power supplying terminal of the motor M. A contact c of the switch SW is connected to the other power supplying terminal of the motor M and a collector of an NPN-type transistor Q3, which is an example of a switch element including a control terminal. The emitter of the transistor Q3 is connected to the power receiving electrode Sa2, and the base of the transistor Q3 is connected to a main body control unit CP. A field Effect Transistor (FET) may be used in place of the power transistor Q3.

As shown in Fig. 4, the collector of the transistor Q1 is connected to the main body control unit CP, and the base of the transistor Q1 is connected to the collector of an NPN-type transistor Q2, which is an example of a switch element including a control terminal. The emitter of the transistor Q2 is connected to ground, and the base of the transistor Q2 is connected to the cathode of a diode D1 and the cathode of a diode D2. The anode of the diode D1 is connected to the contact a of the switch SW, and the anode of the diode D2 is connected to the main body control unit CP. The contact a of the switch SW is also connected to the main body control unit CP via a buffer BF.

The main body 11 includes a voltage measurement unit 41 and a notification unit 42. The voltage measurement unit 41 measures the voltage applied between the two power receiving electrodes Sa1 and Sa2 and provides the measurement result to the main body control unit CP. When the battery pack 12 is in over-discharged, the notification unit 42 notifies the user of such a situation. The notification unit 42 includes a light emitting portion that emits light, such as a light emitting diode, and a drive circuit that drives the light emitting portion. The notification unit 42 illuminates the light emitting portion to notify the user that the rechargeable battery 32 (battery pack 12) is over-discharged. The notification unit 42 may include a noise generation portion that generates noise such as a buzzer, and a drive circuit that drives the noise generation portion. In such a case, the notification unit 42 issues the noise from the noise generation portion to notify the user that the rechargeable battery 32 is over-discharged.

The switch SW is configured to cooperate with the trigger switch 25. When the trigger switch 25 is operated (pulled), the contact a and the contact b of the switch SW are connected. When the trigger switch 25 is released, the contact a and the contact c of the switch SW are connected.

In such a configuration, the switch SW, the buffer BF, the transistors Q1 and Q2, and the diodes D1, D2 form a power supplying control unit. The power supplying control unit starts and stops the supply of power from the rechargeable battery 32 to the main body control unit CP. The power supplying control unit also activates the main body control unit CP in response to the operation of the trigger switch 25 when the battery pack 12 is attached to the main body 11. Specifically, when the battery pack 12 is attached to the main body 11 and the trigger switch 25 is operated, the contact a and the contact b of the switch SW are connected. This supplies voltage from the battery pack 12 to the buffer BF via the power receiving electrode Sa1. The buffer BF adjusts the voltage from the battery pack 12 to an input voltage (e.g., 5V) of the main body control unit CP and supplies the voltage to the main body control unit CP. In other words, when the trigger switch 25 is operated, the output voltage of the buffer BF is switched from a low level of about 0 V to a high level (e.g., about 5V). Further, the connection of the contacts a and b of the switch SW supplies voltage from the battery pack 12 to the base of the transistor Q2 via the power receiving electrode Sa1 and the diode D1. This activates the transistors Q2 and Q1, and power is supplied from the battery pack 12 to the main body control unit CP via the power receiving electrode Sa1 and the transistor Q1.

When supplied with power from the power receiving electrode Sa1, the main body control unit CP starts various controls for operating the main body 11. The main body control unit CP then applies voltage to the base of the transistor Q2 via the diode D2, and performs a power supply self-sustaining control that sustains the power supply to the main body control unit CP.

When the trigger switch 25 is released, the contact a and the contact b of the switch SW are disconnected. Thus, voltage is not supplied from the battery pack 12 to the buffer BF via the power receiving electrode Sa1. The buffer BF supplies the main body control unit CP with an output voltage having a low level L of about 0 V to indicate that the trigger switch 25 has been released. Further, voltage is no longer applied from the battery pack 12 to the base of the transistor Q2 via the power receiving electrode Sa1 and the diode D1. However, the power supply self-sustaining control of the main body control unit CP keeps the transistor Q2 activated for a predetermined time Tps. The transistor Q2 is then deactivated when the power supply self-sustaining control of the main body control unit CP is stopped. This deactivates the transistor Q1 and stops the supply of power from the rechargeable battery 32 to the main body control unit CP. The predetermined time Tps is set in accordance with the specification to, for example, thirty seconds, one minute, or two minutes. The predetermined time Tps may also be set taking into consideration of the subject controlled by the main body control unit CP after the trigger switch 25 is released. Preferably, the predetermined time Tps is set taking into consideration the time after the trigger switch 25 is released that the user uses to input a torque value of the motor M, an additional fastening amount, and the like with a setting input unit (not shown) and the time during which the notification unit 42 is illuminated for recognition by the user.

In the present embodiment, the trigger switch 25 includes a variable resistor, such as a potentiometer, arranged in a power supply line of the motor M between the two power receiving electrodes Sa1 and Sa2. An operation shaft, which operates the variable resistor, is rotated in accordance with the pulled amount of the trigger switch 25, and the voltage applied to the variable resistor is divided in accordance with the rotation of the operation shaft. This provides the main body control unit CP with a divisional voltage corresponding to the pulled amount as an operation signal.

The main body control unit CP controls the activation period of the transistor Q3 in accordance with the operation signal from the trigger switch 25 to control the activation and deactivation of the motor M and the rotation speed of the motor M. For example, the main body control unit CP performs PWM control to set the activation period of the transistor Q3. In this configuration, the transistor Q3 configures a pulse control unit 43 that controls the rotation generated by the motor M in accordance with the control of the main body control unit CP.

The main body control unit CP determines whether or not the voltage measured by the voltage measurement unit 41 is lower than or equal to a predetermined over-discharge voltage threshold S1. When the voltage measured by the voltage measurement unit 41 is lower than or equal to the over-discharge voltage threshold S1, the main body control unit CP gradually decreases the power supplied to the motor M from the two power receiving electrodes Sa1 and Sa2 with the pulse control unit 43 and then stops supplying power to the motor M.

When the trigger switch 25 is released (pulled amount is zero), the contact a of the switch SW is connected to the contact c. This short-circuits the power supplying terminals of the motor M, and the rotation of the motor M generates back electromotive force that applies a brake to the rotation of the motor M.

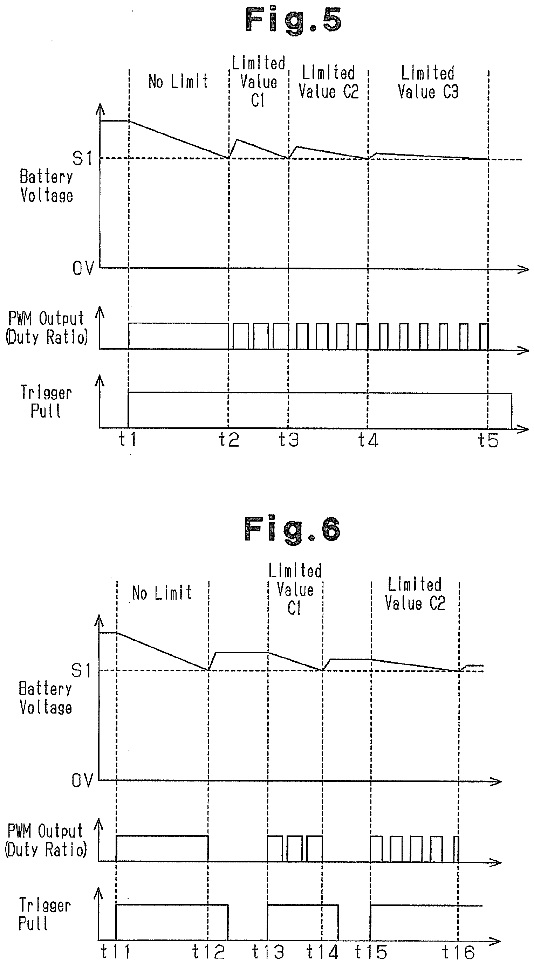

An example of an operation of the power tool 10 based on the battery voltage will now be described referring to Figs. 4 and 5. This operation reduces the influence of the internal resistance.

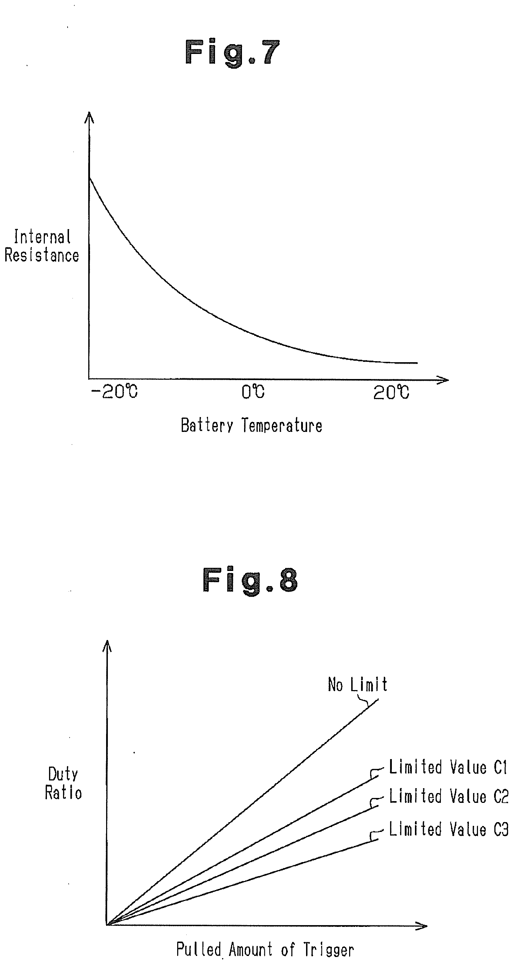

As shown in Fig. 5, at time t1, the user fully pulls the trigger switch 25, and the pulse control unit 43 drives the motor M at a duty ratio of 100% to decrease the voltage of the battery pack 12 (rechargeable battery 32). When the voltage of the battery pack 12 decreases and, at time t2, becomes lower than or equal to a discharge detection voltage S1, which is a predetermined threshold, the main body control unit CP decreases the duty ratio of the pulse control unit 43 to a limited value C1 (e.g., duty ratio of 80%). This reduces the load current flowing to the motor. Fig. 8 shows the PWM duty ratio with respect to the pulled amount of the trigger switch 25 when three limited values C1 to C3 are set and when there is no limitation. As shown in Fig. 8, the maximum current flowing to the motor M may be restricted by limiting the duty ratio when the trigger switch 25 is fully pulled. This decreases the voltage drop caused by the internal resistance in the battery pack 12 and increases the voltage of the battery pack 12.

When the power tool 10 is continuously used, the voltage of the battery pack 12 decreases again. When the voltage of the battery pack 12 decreases and becomes lower than or equal to the discharge detection voltage S1 at time t3, the main body control unit CP decreases the duty ratio of the pulse control unit 43 to the limited value C2 (e.g., duty ratio of 60%). This reduces the load current flowing to the motor M, decreases the voltage drop caused by the internal resistance in the battery pack 12, and increases the voltage of the battery pack 12.

When the power tool 10 is further continuously used, the voltage of the battery pack 12 decreases again. When the voltage of the battery pack 12 decreases and becomes lower than or equal to the discharge detection voltage S1 at time t4, the main body control unit CP decreases the duty ratio of the pulse control unit 43 to a limited value C3 (e.g., duty ratio 40%), which imposes the maximum restriction on the duty ratio in the present embodiment. This reduces the load current flowing to the motor M, decreases the voltage drop caused by the internal resistance in the battery pack 12, and increases the voltage of the battery pack 12. Then, when the voltage of the battery pack 12 decreases again and becomes lower than or equal to the discharge detection voltage S1 at time t5 when the duty ratio is at the limited value C3, the main body control unit CP deactivates the pulse control unit 43 to stop the motor M. This suppresses over-charging of the battery pack 12.

The advantages of the present embodiment will now be described.
(1) The main body control unit CP performs PWM control on the output of the motor M. Whenever the voltage detected by the voltage measurement unit 41 decreases and becomes lower than or equal to the discharge detection voltage S1, which is a predetermined value, the main body control unit CP drives the motor M at a duty ratio that is lower than the duty ratio used before the voltage decreased and became lower than or equal to the discharge detection voltage S1. In this manner, the load current flowing to the motor M is reduced by limiting the duty ratio to a lower value whenever the detection voltage becomes lower than or equal to the discharge detection voltage S1. This decreases the voltage drop caused by the internal resistance in the battery pack 12, increases the voltage of the battery pack 12, and allows for the power tool 10 to be continuously used.
(2) If the detected voltage decreases and becomes lower than or equal to the discharge detection voltage S1 at time t5, which is when the duty ratio is at the limited value C3 that imposes the maximum restriction on the duty ratio, the main body control unit CP deactivates the pulse control unit 43 to stop the motor M. This suppresses over-discharging of the battery pack 12.

In the embodiment described above, the temperature of the battery pack 12 may be detected, and the control of Fig. 5 may be performed only when the temperature decreases and becomes lower than or equal to a predetermined temperature X. This is because the internal resistance increases as the internal temperature of the battery pack 12 decreases as shown in Fig. 7, and the voltage of the battery pack 12 has a tendency of decreasing and becoming lower than or equal to the discharge detection voltage S1 due to the flow of an inrush current or the like when the temperature of the battery pack 12 is low. The predetermined temperature X may be about 5°C when the battery pack 12 is a lithium-ion battery although this value may be changed.

In the embodiment described above, to change the motor output, PWM control, which changes the duty ratio, is performed. However, a different process may be performed to change the motor output.

In the embodiment described above, the control shown in Fig. 5 is performed when the trigger switch 25 is fully pulled. Instead, for example, the control shown in Fig. 6 may be performed. Referring to Figs. 4 and 6, at time t11, the trigger switch 25 is fully pulled by the user, and the motor M is operated at the duty ratio of 100% by the pulse control unit 43. This decreases the voltage of the battery pack 12 (rechargeable battery 32). At time t12, when the voltage of the battery pack 12 decreases and becomes lower than or equal to the discharge detection voltage S1, which is a predetermined threshold, the main body control unit CP deactivates the pulse control unit 43 to stop the motor M.

When the user releases the trigger switch 25 and pulls the trigger switch 25 again at time t13, the main body control unit CP decreases the duty ratio of the pulse control unit 43 to the limited value C1 (e.g., duty ratio of 80%) to reduce the load current flowing to the motor M. This decreases the voltage drop caused by the internal resistance in the battery pack 12 and increases the voltage of the battery pack 12.

When the power tool 10 is further continuously used, the voltage of the battery pack 12 decreased again. When the voltage of the battery pack 12 decreases and becomes lower than or equal to the discharge detection voltage S1 at time t14, the main body control unit CP deactivates the pulse control unit 43 and stops the motor M.

When the user releases the trigger switch 25 and pulls in the trigger switch 25 again at time t15, the main body control unit CP decreases the duty ratio of the pulse control unit 43 to the limited value C2 (e.g., duty ratio of 60%) to reduce the load current flowing to the motor M. This decreases the voltage drop caused by the internal resistance in the battery pack 12 and increases the voltage of the battery pack 12.

In the same manner as the embodiment described above, when this control is repeated and the voltage of the battery pack 12 decreases again and becomes lower than or equal to the discharge detection voltage S1 and the duty ratio is at the limited value C3 that imposes the maximum restriction on the duty ratio, the main body control unit CP deactivates the pulse control unit 43 to stop the motor M. This suppresses over-discharging of the battery pack 12.

In the embodiment described above, the main body control unit CP detects over-discharging from the voltage measured by the voltage measurement unit 41. However, over-discharging may be detected with the battery pack 12 instead of the voltage measurement unit 41, and the battery pack 12 may notify the main body control unit CP of the detection result. For example, as shown by the broken lines in Fig. 4, the main body 11 may include a main body signal electrode Sa3 that receives an over-discharge signal from the battery pack 12. The main body side signal electrode Sa3 is electrically connected to the main body control unit CP. Further, the battery pack 12 may include a battery cell voltage measurement unit 33, a battery control unit 34, and a battery signal electrode Sb3. The battery cell voltage measurement unit 33 measures the voltages of an n number of battery cells Ce1 to Cen and provides the measurement results to the battery control unit 34. The battery cell voltage measurement unit 33 includes a resistance voltage dividing circuit that detects the voltage across the terminals of each of the battery cells Ce1 to Cen. When one of the n number of voltages of the n number of battery cells Ce1 to Cen measured by the battery cell voltage measurement unit 33 is lower than or equal to a predetermined over-discharge voltage S1 of the battery cell, the battery control unit 34 outputs an over-discharge signal indicating that the battery cell is over-discharged. When the battery cell is not over-discharged, the battery control unit 34 provides the battery side signal electrode Sb3 with a control signal (e.g., signal having low level) indicating that the battery cell is not over-discharged. When the battery cell is over-discharged (when the voltage is lower than or equal to the voltage S1), the battery control unit 34 provides the battery side signal electrode Sb3 with a control signal (e.g., signal having high level, over-discharge signal) indicating that the battery cell is over-discharged. The main body control unit CP limits the duty ratio of the pulse control unit 43 based on the control signal like in the embodiment described above,.

In the embodiment described above, the power tool 10 is used as a drill driver but may be used as, for example, an impact driver, an impact trench, a hammer drill, a vibration drill, a jigsaw, or a sealing gun.

The present examples and embodiments are to be considered as illustrative and not restrictive, and the invention is not to be limited to the details given herein, but may be modified within the scope and equivalence of the appended claims.

## Claims

1. A power tool (10) including:
a motor (M);
a rechargeable battery (32) adapted to supply power to the motor (M);
a voltage measurement unit (S) adapted to detect a battery voltage of the rechargeable battery (32);
a switch (25, SW) that is operable by a user, wherein the switch drives the motor (M) when operated by the user; and
a control unit (41) that is adapted to control the power supplied to the motor (M) in response to the operation of the switch (25, SW), the power tool **characterized in that**:
whenever the voltage detected by the voltage measurement unit (S) decreases and becomes lower than or equal to a predetermined value, the control unit (41) is adapted to drive the motor (M) to generate an output that is smaller than that before the voltage decreased and became lower than or equal to the predetermined value,
the control unit (41) is adapted to perform PWM control on the output of the motor (M), **characterized in that** the control unit (41) is adapted to set a duty ratio of the PWM control to a first limited value that is lower than the duty ratio before the voltage decreased and became lower than or equal to the predetermined value when the voltage detected by the voltage measurement unit (S) decreases and becomes lower than or equal to the predetermined value, and
the control unit (41) is adapted to set the duty ratio to a second limited value that is lower than the first limited value when the voltage detected by the voltage measurement unit (S) decreases and becomes lower than or equal to the predetermined value again.

2. The power tool according to claim 1, **characterized in that**:
whenever the voltage detected by the voltage measurement unit (S) decreases and becomes lower than or equal to the predetermined value, the control unit (41) is adapted to drive the motor (M) while lowering the duty ratio in the order of 80%, 60%, and 40%.

## Patentansprüche

1. Kraftgetriebenes Werkzeug (10), welches Folgendes beinhaltet:
einen Motor (M);
eine wiederaufladbare Batterie (32), die zum Versorgen des Motors (M) mit Strom geeignet ist;
eine Spannungsmesseinheit (S), die zum Erkennen einer Batteriespannung der wiederaufladbaren Batterie (32) geeignet ist;
einen Schalter (25, SW), der durch einen Benutzer bedient werden kann, wobei der Schalter den Motor (M) antreibt, wenn er durch den Benutzer bedient wird; und
eine Steuereinheit (41), die zum Steuern des Stroms, mit dem der Motor (M) versorgt wird, als Reaktion auf den Betrieb des Schalters (25, SW) geeignet ist, wobei das kraftgetriebene Werkzeug **dadurch gekennzeichnet ist, dass**:
immer wenn die Spannung, die durch die Spannungsmesseinheit (S) erkannt wird, abnimmt und geringer als ein oder gleich einem vorbestimmten Wert wird, die Steuereinheit (41) zum Antreiben des Motors (M) zum Erzeugen einer Ausgabe, die kleiner als die Ausgabe, bevor die Spannung abnahm und geringer als der oder gleich dem vorbestimmten Wert wurde, ist, geeignet ist,
die Steuereinheit (41) zum Durchführen von PWM-Steuerung an der Ausgabe des Motors (M) geeignet ist, **dadurch gekennzeichnet, dass**
die Steuereinheit (41) zum Einstellen eines Tastverhältnisses der PWM-Steuerung auf einen ersten begrenzten Wert, der geringer als das Tastverhältnis, bevor die Spannung abnahm und geringer als der oder gleich dem vorbestimmten Wert wurde, ist, wenn die Spannung, die durch die Spannungsmesseinheit (S) erkannt wird, abnimmt und geringer als der oder gleich dem vorbestimmten Wert wird, geeignet ist, und
die Steuereinheit (41) zum Einstellen des Tastverhältnisses auf einen zweiten begrenzten Wert, der geringer als der erste begrenzte Wert ist, wenn die Spannung, die durch die Spannungsmesseinheit (S) erkannt wird, wieder abnimmt und geringer als der oder gleich dem vorbestimmten Wert wird, geeignet ist.

2. Kraftgetriebenes Werkzeug nach Anspruch 1, **dadurch gekennzeichnet, dass**:
immer wenn die Spannung, die durch die Spannungsmesseinheit (S) erkannt wird, abnimmt und geringer als der oder gleich dem vorbestimmten Wert wird, die Steuereinheit (41) zum Antreiben des Motors (M) geeignet ist, während das Tastverhältnis in der Reihenfolge von 80 %, 60 % und 40 % gesenkt wird.

## Revendications

1. Outil électrique (10) comprenant :
un moteur (M) ;
une batterie rechargeable (32) adaptée pour alimenter le moteur (M) ;
une unité de mesure de tension (S) adaptée pour détecter une tension de batterie de la batterie rechargeable (32) ;
un commutateur (25, SW) qui est actionnable par un utilisateur, le commutateur excitant le moteur (M) lorsqu'il est actionné par l'utilisateur ; et
une unité de commande (41) qui est adaptée pour commander la puissance fournie au moteur (M) en réponse à l'actionnement du commutateur (25, SW), l'outil électrique étant **caractérisé en ce que** :
lorsque la tension détectée par l'unité de mesure de tension (S) diminue et devient inférieure ou égale à une valeur prédéterminée, l'unité de commande (41) est adaptée pour exciter le moteur (M) pour générer une sortie qui est inférieure à celle avant que la tension diminue et devienne inférieure ou égale à la valeur prédéterminée,
l'unité de commande (41) est adaptée pour effectuer une commande de modulation de largeur d'impulsions (PWM) sur la sortie du moteur (M),
**caractérisé en ce que**
l'unité de commande (41) est adaptée pour définir un facteur de marche de la commande PWM à une première valeur limitée qui est inférieure au facteur de marche avant que la tension diminue et devienne inférieure ou égale à la valeur prédéterminée lorsque la tension détectée par l'unité de mesure de tension (S) diminue et devient inférieure ou égale à la valeur prédéterminée, et
l'unité de commande (41) est adaptée pour définir le facteur de marche à une deuxième valeur limitée qui est inférieure à la première valeur limitée lorsque la tension détectée par l'unité de mesure de tension (S) diminue et devient à nouveau inférieure ou égale à la valeur prédéterminée.

2. Outil électrique selon la revendication 1, **caractérisé en ce que** :
lorsque la tension détectée par l'unité de mesure de tension (S) diminue et devient inférieure ou égale à la valeur prédéterminée, l'unité de commande (41) est adaptée pour exciter le moteur (M) tout en diminuant le facteur de marche de l'ordre de 80 %, 60 % et 40 %.
